(19) Europäisches Patentamt
European Patent Office
Office européen des brevets

(11) **EP 0 752 758 A1**

(12) **EUROPÄISCHE PATENTANMELDUNG**

(43) Veröffentlichungstag:
08.01.1997 Patentblatt 1997/02

(51) Int. Cl.$^6$: **H03H 11/04**

(21) Anmeldenummer: 96109429.9

(22) Anmeldetag: 12.06.1996

(84) Benannte Vertragsstaaten:
**DE ES FR GB IT**

(30) Priorität: **04.07.1995 DE 19524409**

(71) Anmelder: **SIEMENS AKTIENGESELLSCHAFT**
**80333 München (DE)**

(72) Erfinder: **Fiesel, Hans, Dipl.-Ing.**
**79286 Glottertal (DE)**

(54) **Filterschaltung mit veränderbarer Übertragungsfunktion**

(57) Eine Filterschaltung mit veränderbarer Übertragungsfunktion enthält einen Spannungs-Strom-Wandler (Transkonduktanzverstärker) (1) mit zwei Ausgängen (2, 3). Der erste Ausgang (2) ist über einen Kondensator (4) nach Masse geschaltet, der zweite Ausgang (3) über einen Widerstand (6). Die an den Ausgängen (2, 3) des Spannungs-Strom-Wandlers anliegenden Signale werden über ein Verknüpfungsglied (9) zu einem Ausgangssignal (UA) kombiniert. Das am ersten Ausgangsanschluß (2) des Spannungs-Strom-Wandlers (1) abgreifbare Signal wird mittels eines zweiten Verknüpfungsgliedes (5) von einem Eingangssignal (UE) subtrahiert und auf den Spannungs-Strom-Wandler (1) rückgekoppelt. An einem Steueranschluß (8) des Spannungs-Strom-Wandlers (1) ist sein Spannungs-zu-Strom-Übersetzungsverhältnis einstellbar. Diese Einstellung kann aus dem Eingangssignal (UE) und gegebenenfalls mindestens einem der an den Ausgangsanschlüssen (2, 3) des Spannungs-Strom-Wandlers (1) abgreifbaren Signale durch zeitliche und amplitudenmäßige Bewertung erzeugt werden, so daß sich eine von der Eingangssignalamplitude und Eingangssignalfrequenz abhängige nicht-lineare Filterung des Eingangssignals (UE) ergibt.

FIG. 1

**Beschreibung**

Die Erfindung betrifft eine Filterschaltung mit veränderbarer Übertragungsfunktion.

In der nachrichtentechnischen Signalverarbeitung, insbesondere der Audio-Signalverarbeitung, sind oftmals Filter erforderlich, deren Übertragungsfunktion veränderbar sein soll. Die Erfindung bezieht sich insbesondere auf eine Filterschaltung, die die Übertragungsfunktion

$$F(p) = \frac{1+pT}{1+p\frac{T}{K}}, \qquad k = 0, ..., 1,$$

aufweist. Durch Veränderung von k wird die Übertragungsfunktion des Filters verändert. Mit abnehmendem k wird die Dämpfung des Filters für hohe Frequenzen erhöht. Prinzipiell weist die Übertragungsfunktion des Filters mit ansteigenden Frequenzen zuerst einen Durchlaßbereich auf, ab einer ersten Eckfrequenz $f_{G1}$ eine mit 20 dB/Dekade abfallende Flanke und bei einer zweiten Eckfrequenz $f_{G2}$ einen sich anschließenden waagerechten Verlauf. Mit abnehmenden k verschiebt sich die erste Eckfrequenz $f_{G1}$ zu niedrigeren Werten hin, so daß die Dämpfung der höheren Frequenzen zunimmt. Die zweite Eckfrequenz $f_{G2}$ ist unabhängig von k. Die Große k kann dabei durch jegliche Maßnahmen eingestellt werden.

In der europäischen Patentanmeldung EP-A2-0 442 492 ist ein aktives Filter beschrieben, das die oben angegebene Übertragungsfunktion aufweist. Die Filterschaltung enthält einen Stromverstärker mit Differenzeingängen, der eingangsseitig mit einem Eingangssignal des Filters und dem rückgekoppelten Ausgangssignal des Filters gespeist wird. Der einzige Ausgang des Verstärkers ist über einen Kondensator nach Masse verbunden. Der Ausgang des Verstärkers sowie das Eingangssignal werden außerdem jeweils über einen Puffer sowie einen in Serie geschalteten Widerstand geführt. Die Widerstände sind miteinander gekoppelt und mit einem Ausgangspuffer verbunden, an dem das Ausgangssignal abgreifbar ist.

In der Literaturstelle Hampel, Thomas; Palatos, Laszlo: "Entwurf elektrisch steuerbarer Filter mit Transkonduktanzverstärkern", Frequenz 47 (1993) 7 - 8, Seiten 219 bis 223 sind allgemein Anwendungen von Transkonduktanzverstärkern zur Realisierung analoger Filter beschrieben. Die Filtercharakteristik ist unter anderem durch die Veränderung des SpannungsStrom-Übersetzungsfaktors einstellbar.

Die Aufgabe der Erfindung besteht darin, eine andere schaltungstechnische Realisierung für eine Filterschaltung anzugeben, die die oben beschriebene Übertragungsfunktion aufweist.

Erfindungsgemäß wird diese Aufgabe durch eine Filterschaltung nach den Merkmalen des Patentanspruchs 1 gelost.

Bei der erfindungsgemäßen Filterschaltung ist im Rückkopplungszweig nur eine geringe Zeitkonstante, nämlich die durch das kapazitive Element gebildete wirksam. Diese Zeitkonstante belastet nur einen Teil der Gesamtschaltung. Die Filterschaltung ist ohne weiteres integrierbar. Gegebenenfalls muß nur das kapazitive Element als diskreter Kondensator außerhalb der integrierten Schaltung vorgesehen werden. Da der eine Anschluß des Kondensators mit Bezugspotential verbunden ist und der andere mit dem Rückkopplungszweig der Filterschaltung, ist nur ein einziger Anschlußpin der integrierten Schaltung zum Anschluß des Kondensators notwendig.

Um eine signalabhängige Einstellung der Größe k und somit der Übertragungsfunktion des Filters zu erreichen, kann eine Steuerungseinrichtung zur Steuerung der Verstärkung des Spannungs-Strom-Wandlers vorgesehen werden, der das Eingangssignal zugeführt wird. Gegebenenfalls können auch eines oder mehrere Ausgangssignale des Spannungs-Strom-Wandlers oder davon abgeleitete Signale in die Steuerungseinrichtung eingespeist werden. Die Steuerungseinrichtung wendet zur Erzeugung des von ihr abgegebenen Steuersignals auf ihre Eingangssignale eine amplitudenabhängige Verarbeitung und/oder eine zeitlich wirksame Verarbeitung an, z. B. eine Zeitverzögerung, die auch von der Signalamplitude abhängig sein kann. Somit ergibt sich eine von der Eingangssignalgröße gesteuerte frequenzabhängige Filterung. Hierbei ist vorteilhaft, daß die Steuerungseinrichtung einen Signalverarbeitungszweig bildet, der parallel zu den die Filterung bewirkenden Zweigen liegt und somit keine parasitären Zeitkonstanten in diese Verarbeitungszweige einfügt.

Nachfolgend wird die Erfindung anhand des in der Zeichnung dargestellten Ausführungsbeispiels näher erläutert. Es zeigen:

Figur 1    das Schaltbild einer erfindungsgemäßen Filterschaltung und

Figur 2    typische Verläufe der Übertragungsfunktion in Abhängigkeit von einem Parameter.

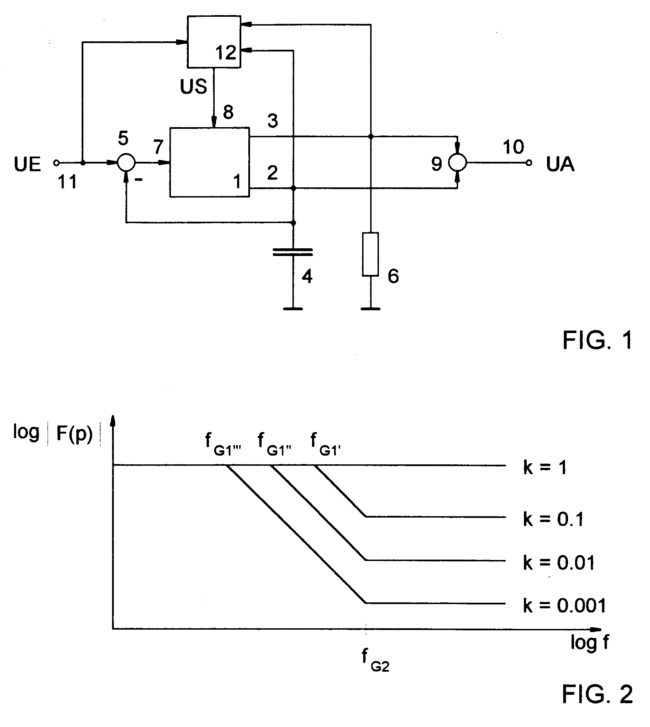

In der Figur 2 sind die Verläufe der Übertragungsfunktion

$$F(p) = \frac{1+pT}{1+p\frac{T}{K}}, \qquad k = 0, ..., 1$$

gezeigt. Für den Fall k = 1 ergibt sich als Übertragungsfunktion eine parallel zur Frequenzachse liegende Gerade. Alle Frequenzen passieren das Filter ungedämpft. Mit zunehmendem k wird eine erste Eckfrequenz $f_{G1}$ wirksam, ab der die Übertragungsfunktion eine mit 20 dB/Dekade abfallende Flanke aufweist. In der Figur 2 sind für die drei dargestellten Werte von k die ersten Eckfrequenzen mit $f_{G1'}$, $f_{G1''}$, $f_{G1'''}$ bezeichnet. Die abfallende Flanke endet bei einer zweiten Eckfrequenz $f_{G2}$. Ab der zweiten Eckfrequenz $f_{G2} = 1/T$ weist die Übertragungsfunktion einen waagerechten Verlauf auf, wobei die Dämpfung mit abnehmendem k zunimmt.

Gemäß Figur 1 enthält ein Filter mit einer derartigen Übertragungsfunktion einen Spannungs-Strom-Wandler, der vorzugsweise als Transkonduktanzverstärker 1 (OTA: Operational Transconductance Amplifier) ausgeführt ist. Der OTA 1 weist zwei Ausgänge 2, 3 auf, die in Zeitverlauf und Amplitude gleiche Signale aufweisen. Dies kann dadurch erreicht werden, daß der OTA 1 für die Ausgänge 2, 3 je eine identisch aufgebaute Ausgangsstufe enthält, die vom gleichen internen Steuersignal gespeist werden. Der Ausgang 2 ist über ein kapazitives Element, beispielsweise einen Kondensator 4 mit Bezugspotential (Masse) verbunden. Der Ausgang 2 wird außerdem in einem Verknüpfungselement 5 vom Eingangssignal UE subtrahiert. Das vom Verknüpfungselement 5 abgegebene Differenzsignal wird dem Signaleingang des OTA 1 zugeführt. Der andere Ausgang 3 des OTA 1 ist über ein ohmsches Element, beispielsweise einen Widerstand 6 mit Masse verbunden. Bekanntlich besteht die Wirkungsweise des OTA darin, die an seinem Eingangsanschluß 7 anliegende Spannung mit einem (nicht dargestellten) Referenzwert zu vergleichen und in Abhängigkeit vom Spannungssignal an den Ausgängen einen proportionalen Strom zu liefern. Der Spannungs-zu-Strom-Übersetzungsfaktor $g_m$ des OTA 1 ist über einen Steuereingang 8 steuerbar. Die an den Ausgangsanschlüssen 2, 3 des OTA 1 anliegenden Signale werden in einem Verknüpfungsglied 9, beispielsweise einem Addierer zusammengeführt. Am Ausgangsanschluß 10 des Verknüpfungsglieds 9 liegt das gefilterte Ausgangssignal UA an.

Der Signalverarbeitungspfad zwischen dem Eingangsanschluß 11 und dem Ausgangsanschluß 2 des OTA einschließlich des Rückkopplungszweigs aus Ausgangsanschluß 2, Kondensator 4, Verknüpfungselement 5 wirkt als Tiefpaß. Das am Anschluß 2 anliegende Signal ist das tiefpaßgefilterte Eingangssignal UE. Die Übertragungsfunktion des Teilsystems vom Eingangsanschluß 11 zum Anschluß 2 lautet folglich

$$F1(p) = \frac{1}{1+p\dfrac{C}{g_m}}.$$

Am Anschluß 3 des OTA 1 liegt der gleiche Strom wie am Anschluß 2 vor, wobei der Anschluß 3 im Unterschied dazu durch den Widerstand 6 nach Masse verbunden ist. Die Übertragungsfunktion vom Eingangsanschluß 11 zum Anschluß 3 ist folglich durch eine differenzierende Wirkung ergänzt, die durch den Widerstand 6 anstelle des Kondensators 4 bewirkt wird. Diese Teilübertragungsfunktion lautet folglich

$$F2(p) = \frac{pCR}{1+p\dfrac{C}{g_m}}.$$

Die Gesamtübertragungsfunktion F(p) zwischen Eingangsanschluß 11 und Ausgangsanschluß 10 ergibt sich folglich als Summe der beiden Teilübertragungsfunktionen F(p) = F1(p) + F2(p). Dies entspricht der gewünschten Übertragungsfunktion, wenn T = RC und k = R · $g_m$ gesetzt wird. Hieraus ist erkennbar, daß durch geeignete Veränderung der Spannungs-zu-Strom-Verstärkung $g_m$ des OTA 1 die Übertragungsfunktion in der gewünschten Weise veränderbar ist.

Der in der Figur 2 gezeigte Verlauf der Übertragungsfunktionen wird bis zur zweiten Eckfrequenz $f_{G2}$ durch das durch die Übertragungsfunktion F1(p) gebildete Tiefpaßverhalten des Zweigs vom Eingangsanschluß 11 zum Anschluß 2 bestimmt; für Frequenzen oberhalb der zweiten Eckfrequenz $f_{G2}$ wird das differenzierende Verhalten der Teilübertragungsfunktion F2(p) des Zweigs vom Eingangsanschluß 11 zum Anschluß 3 wirksam, so daß sich die Flanken beider Teilübertragungsfunktionen kompensieren, so daß der in Figur 2 gezeigt waagerechte weitere Verlauf der Gesamtübertragungsfunktion resultiert.

Die Größe k kann durch Einstellung der Verstärkung $g_m$ des OTA 1 verändert werden. Hierzu ist die Einspeisung eines Steuersignals US am Anschluß 8 des OTA 1 vorgesehen. Zur Erzeugung dieses Steuersignals US dient eine Steuereinrichtung 12. Die Steuereinrichtung 12 sorgt für den gewünschten zeitlichen Verlauf des Steuersignals US am Anschluß 8, um die gewünschte Einstellung der OTA-Verstärkung $g_m$ zu erhalten. Beispielsweise kann das Steuersignal US in Abhängigkeit vom Betriebszustand der Filterschaltung erzeugt werden. Hierzu wird der Filterschaltung 12 das am Eingangsanschluß 11 eingespeiste Eingangssignal UE und/oder ein oder beide der an den Anschlüssen 2, 3 anliegenden Signale eingespeist. Zweckmäßigerweise werden die in die Einrichtung 12 eingespeisten Signale zeitlich und amplitudenmäßig bewertet. Beispielsweise kann eine zur Erzeugung des Steuersignals US wirksame Zeitverzögerung amplitudenabhängig oder amplitudenschwankungsabhängig eingestellt werden. Insgesamt bewirkt die Filterschaltung dann eine von der Eingangssignalgröße und der Eingangssignalfrequenz abhängige nicht-lineare Filterung des Eingangssignals UE.

**Patentansprüche**

1. Filterschaltung mit veränderbarer Übertragungsfunktion, die

   - einen Eingangsanschluß (11) für ein Eingangssignal (UE) und einen Ausgangsanschluß (10) zum Abgriff eines Ausgangssignals (UA) aufweist,
   - einen Spannungs-Strom-Wandler (1) mit einem ersten und einem zweiten jeweils gleiche Ausgangssignale liefernden Ausgangsanschluß (3, 2), die über ein erstes Verknüpfungselement (9) mit dem Ausgangsanschluß (10) der Filterschaltung verbunden sind und von denen der erste (3) über ein ohmsches Element (6) und der zweite (2) über ein kapazitives Element (4) mit einem Anschluß für ein Bezugspotential verbunden ist, sowie

- ein zweites Verknüpfungselement (5), das eingangsseitig mit dem Eingangsanschluß (11) der Filterschaltung und invertiert mit dem zweiten Ausgangsanschluß (2) des Spannungs-Strom-Wandlers (1) verbunden ist und ausgangsseitig mit einem Eingangsanschluß (7) des Spannungs-Strom-Wandlers (1), und bei der

- der Spannungs-Strom-Wandler (1) über ein an einem Steueranschluß (8) anlegbares Steuersignal (US) in bezug auf seine Spannungs-zu-Stromübersetzung steuerbar ist.

2. Filterschaltung nach Anspruch 1,
   **dadurch gekennzeichnet**, daß
   der Spannungs-Strom-Wandler (1) ein Transkonduktanzverstärker ist, dessen Verstärkung über das Steuersignal (US) einstellbar ist.

3. Filterschaltung nach Anspruch 1 oder 2,
   **dadurch gekennzeichnet**, daß
   die an den Ausgangsanschlüssen (2, 3) des Spannungs-Strom-Wandlers (1) abgreifbaren Stromausgangssignale im Zeitverlauf und der Amplitude gleich sind.

4. Filterschaltung nach einem der Ansprüche 1 bis 3,
   **dadurch gekennzeichnet**, daß
   die Ausgangsanschlüsse (2, 3) des Spannungs-Strom-Wandlers (1) durch je eine Ausgangsstufe angesteuert werden und daß die Ausgangsstufen vom gleichen Ansteuersignal gesteuert werden.

5. Filterschaltung nach einem der Ansprüche 1 bis 4,
   **dadurch gekennzeichnet**, daß
   das Steuersignal (US) durch eine Steuereinrichtung (8) erzeugt wird, durch die eine zeitliche und amplitudenmäßige Bewertung des Eingangssignals (UE) durchgeführt wird.

6. Filterschaltung nach Anspruch 5,
   **dadurch gekennzeichnet**, daß
   der Steuereinrichtung (8) das Eingangssignal (UE) und mindestens eines der an den Ausgangsanschlüssen (2, 3) des Spannungs-Strom-Wandlers (1) abgreifbaren Signale zugeführt wird.

FIG. 1

FIG. 2

Europäisches
Patentamt

# EUROPÄISCHER RECHERCHENBERICHT

Nummer der Anmeldung

EP 96 10 9429

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | IEEE CIRCUITS AND DEVICES MAGAZINE, Bd. 1, Nr. 2, März 1985, NEW YORK US, Seiten 20-32, XP002015888 RANDALL L. GEIGER ET AL: "ACTIVE FILTER DESIGN USING OPERATIONAL TRANSCONDUCTANCE AMPLIFIERS: A TUTORIAL" * Seite 22, Spalte 2, Zeile 42 - Seite 25, Spalte 2, Zeile 4; Abbildungen 5,6 * ----- | 1,2 | H03H11/04 |
|  |  |  | RECHERCHIERTE SACHGEBIETE (Int.Cl.6) |
|  |  |  | H03H |

Der vorliegende Recherchenbericht wurde für alle Patentansprüche erstellt

| Recherchenort | Abschlußdatum der Recherche | Prüfer |
|---|---|---|
| DEN HAAG | 15.Oktober 1996 | Coppieters, C |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

................................................................

& : Mitglied der gleichen Patentfamilie, übereinstimmendes
    Dokument

EPO FORM 1503 03.82 (P04C03)